# EUROPÄISCHE PATENTSCHRIFT

(11) **EP 0 442 163 B1**
(45) Veröffentlichungstag und Bekanntmachung des Hinweises auf die Patenterteilung: **27.07.1994**
(21) Anmeldenummer: 90203467.7
(22) Anmeldetag: 21.12.1990
(51) Int. Cl.: C23C 14/28, C23C 16/44, C23C 16/50

(54) **Verfahren zum Herstellen von ultrafeinen Partikeln und deren Verwendung**
Method for production of ultrafine particles and their use
Méthode de production de particules ultrafines et leur utilisation

(30) Priorität: 12.01.1990 DE 4000690
(43) Veröffentlichungstag der Anmeldung: 21.08.1991
(73) Patentinhaber: Philips Patentverwaltung GmbH, 22335 Hamburg (DE); Philips Electronics N.V., 5621 BA Eindhoven (NL)
(72) Erfinder: Gärtner, Georg, Dr., W-5100 Aachen (DE); Lydtin, Hans, Dr., W-5190 Stolberg (DE)
(74) Vertreter: Volmer, Georg, Dipl.-Ing.

(56) Entgegenhaltungen:
- EP-A- 0 143 122
- EP-A- 0 265 886
- DE-A- 3 800 680
- PATENT ABSTRACTS OF JAPAN, Band 10, Nr. 49 (C-330)[2106], 26. Februar 1986; & JP-A-60 194 066
- JOURNAL OF APPLIED PHYSICS, Band 66, Nr. 7, Oktober 1989, Seiten 3304-3308; G.-M. CHOW et al.: "Nanometer-size fiber composite synthesis by laser-inducedreactions"
- PATENT ABSTRACTS OF JAPAN, Band 9, Nr. 272 (M-425)[1995], 30. Oktober 1985; & JP-A-60 116 705
- PATENT ABSTRACTS OF JAPAN, Band 10, Nr. 245 (C-368)[2301], 22. August 1986; & JP-A-61 73 881
- EXTENDED ABSTRACTS/ELECTROCHEMICAL SOCIETY, Band 87-2, Oktober 1987, Seiten 1545-1546; D.P. STINTON: "Ceramic composites by chemical vapor infiltration"

## Beschreibung

Die Erfindung betrifft ein Verfahren zum Herstellen von ultrafeinen Partikeln mit Durchmessern im Bereich von 1 bis 100 nm, die durch Laserstrahlverdampfung aus einem Target erzeugt werden.

Unter ultrafeinen Partikeln sind Partikel mit Durchmessern im Bereich von 1 bis 100 nm zu verstehen; derartige Partikel sind demnach kleiner als die Partikel konventioneller feiner Pulver und größer als Cluster von Atomen (Chikara Hayashi, J.Vac.Sci.Technol. A5(4), Jul/Aug 1987, S. 1375-1384, und Physics Today, December 1987, S. 44-51).

Anwendungsmöglichkeiten für ultrafeine Partikel bestehen laut Hayashi a.a.0.
- in Farbstoffen, Pigmenten, Klebstoffen und Kataly satoren,
- für ultrafeine Partikel aus Al₂O₃, carburiertem Wolfram, Si₃N₄ und anderen hitze- und säurebeständigen Carbiden und Nitriden von aktiven Metallen und Seltenerdmetallen in Werkzeugen, Keramiken und hitzebeständigen Materia lien,
- zum Dispersionshärten, wobei ultrafeine Partikel aus einem Wirtsmaterial dispergiert werden und die Mischung gesintert oder der Einwirkung eines Katalysators aus gesetzt wird,
- in Aerosolen für Land- und Forstwirtschaft, Militärtechnik und Medizin,
- für ultrafeine Partikel aus magnetischen Legierungen in magnetischen Aufzeichnungsmaterialien, z.B. Ton- und Videobänder, und
- in der Mikrobiologie.

Die Herstellung von ultrafeinen Partikeln erfolgt laut Hayashi mit induktionsbeheizten Tiegeln, in Lichtbogenöfen, Plasmaöfen und in den mit Sauerstoff angereicherten Flammen von Brennern, wobei Hayashi das GEM-Verfahren (Gas Evaporation Method) bevorzugt, d.h. die Verdampfung und Kondensation in einem permanenten Gas.

Ferner beschreibt Hayashi die Flotation and den Transport von ultrafeinen Partikeln in einem Gasstrom sowie ein Gas-Beschichtungsverfahren, bei dem ein Gasstrom hoher Geschwindigkeit, der ultrafeine Partikel mit sich führt, bei niedrigem Druck, z.B. 1 hPa, auf ein Sabstrat aufprallt.

Aus US-A-4 619 691 ist ein Verfahren zum Herstellen von ultrafeinen Partikeln durch Bestrahlen einer Oberfläche eines Materials mit einem Laserstrahl bekannt. Wenn die Bestrahlung in einer entsprechend gewählten Gasatmosphäre, z.B. in Sauerstoff, Stickstoff, Dichlordifluormethan, Methan oder Propan, durchgeführt wird, werden ultrafeine Partikel mit einer gewünschten Zusammensetzung erhalten, wobei die Zusammensetzung entweder gleich der oder unterschiedlich von der Zusammensetzung des bestrahlten Materials ist. Die Partikelgrößenverteilung wird über den Druck der Gasatmosphäre eingestellt, wobei dieser Druck nicht größer als 1000 hPa ist. Bei der Bestrahlung von Titan unter einem Druck von 1000 hPa werden ultrafeine Partikel mit einem Durchmesserbereich von 5 bis 65 nm erhalten, bei 130 hPa solche mit einem einheitlichen Partikeldurchmesser von 5 nm. Die Leistungsdichte des Laserstrahls liegt zwischen 10⁴ und 10⁷ W/cm². Dem bestrahlten Material kann noch zusätzliche Energie zugeführt werden, z.B. durch einen Lichtbogen, durch Glimmentladung oder durch Elektronenstrahlen.

Aus DE-A-38 00 680 ist ein Verfahren zur Beschichtung eines Substrats in einer Vakuumkammer bekannt, bei dem mit Hilfe eines Laserstrahls ein Target verdampft und der Niederschlag als Beschichtung auf dem Substrat ausgenutzt wird, wobei die Laserstrahlung durch ein optisches Fenster in die Vakuumkammer eingeführt wird und die Niederschlagsbildung auf dem Fenster innerhalb der Vakuumkammer mit Hilfe einer Gaswolke vermieden wird. Das Druckniveau innerhalb der Vakuumkammer liegt im Regelfall zwischen 10⁻² und 10⁻⁶ hPa. Als Gas für die Gaswolke kann ein Inertgas oder zumindest teilweise ein reaktives Gas, das sich mit den verdampften Partikeln des Targets zu einer neuen chemischen Verbindung vereinigt und damit Bestandteil der Beschichtung wird, gewählt werden. Es können Materialien unterschiedlicher Schmelztemperatur und Verdampfungstemperatur nebeneinander verdampfen und als Beschichtungswerkstoff eingesetzt werden. Dabei ist das Target entweder als Festkörpergemisch vorhanden oder als ein Pulver, das aus einem Gemisch von Materialien besteht. Eine gleichmäßige Abnutzung und auch eine Steuerung der Abgabemenge an Verdampfung pro Zeiteinheit können durch Bewegen des Targets gesteuert werden. Durch das Bewegen des Targets sind stets frische Materiallen dem Laserstrahl ausgesetzt und es wird das Einbrennen von Löchern in das Target vermieden. Für den Transport der verdampften Partikel vom Target zum Substrat ist eine Ionisierung der für die Beschichtung vorgesehenen Dämpfe und begleitender Inertgase besonders vorteilhaft. Um die Ionisierung zu unterstützen, kann an der Verdampfungsstelle des Targets und/oder im Bereich des Substrats ein Niederdruckplasma gebildet werden, das beispielsweise durch eine Glimmentladung aufrechterhalten wird. Zur weiteren Unterstützung des Transports der verdampften Partikel auf das Substrat kann letzteres negativ geladen sein.

Die in DE-A-38 00 680 beschriebene Lasermaterialbearbeitung im Hochvakuum liefert Partikel sehr unspezifischer Größe, d.h. sowohl solche im Bereich größer als 1µm als auch Moleküle selbst. Ferner läßt sich ein ausreichend hoher Massenfluß im Hochvakuum nicht bewerkstelligen.

Der Erfindung liegt die Aufgabe zugrunde, das Verfahren der eingangs genannten Art derart zu gestalten, daß das Targetmaterial nahezu vollständig abgetragen und auf diese Weise wirksamer ausgenutzt wird.

Diese Aufgabe wird erfindungsgemäß dadurch gelöst, daß der Laserstrahl relativ zum Target in der Targetrandzone am Targetrand entlang bewegt wird und bei geeigneter Einstellung der Laserparameter Leistung, Leistungsdichte sowie der Relativgeschwindigkeit den Targetrand jeweils komplett abträgt.

Beim erfingungsgemäßen Verfahren wird vom Laserstrahl getroffenes Targetmaterial in Strahlungsrichtung vollständig abgetragen, wobei der größte Teil des Strahls mit dem Target in Wechselwirkung tritt und nur ein kleiner Teil direkt durch das Target hindurchtritt oder am Target vorbeigeht. Es kann also sowohl ein Durchschuß als auch eine Randabtragung erfolgen, indem der Laserstrahl relativ zum Target in der Targetrandzone am Targetrand entlangbewegt wird und bei geeigneter Einstellung der Laserparameter wie Leistung, Leistungsdichte sowie der Relativgeschwindigkeit den Targetrand jeweils komplett abträgt. Die Targetdicke sollte nicht größer als einige mm sein, typischerweise 1 bis 5 mm.

Eine Variante des erfindungsgemäßen Verfahrens ist, daß die abdampfenden ultrafeinen Partikel durch ein Loch im Target hindurch und gegebenenfalls noch durch eine zusätzliche Blende abströmen.

Zweckmäßigerweise wird die Oberfläche des Targets vor Beginn der Abtragung aufgerauht, geschmirgelt oder oxidiert, oder es wird als Target ein poröser Preßling verwendet. Dies wird weiter unten näher erläutert.

Eine weitere Ausgestaltung des erfindungsgemäßen Verfahrens besteht darin, daß verschiedene Materialkomponenten gleichzeitig verdampft und ultrafeine Partikel daraus erzeugt werden.

Um eine Rückkondensation der ultrafeinen Partikel und thermomechanische Spannungen zu vermeiden oder zu reduzieren, wird das Target zweckmäßigerweise direkt oder indirekt (z.B. durch Widerstandsheizung, induktive Heizung oder Laserstrahlheizung) aufgeheizt.

Die Laserstrahlverdampfung aus dem Target erfolgt vorzugsweise vor, im oder hinter dem Fokus eines fokussierten Strahls, wobei die Fokussierung in oder außerhalb einer Targetkammer vorzugsweise durch einen sphärischen fokussierenden Spiegel, der mit Inertgas gespült wird, erfolgt.

Insbesondere für Keramiken ist es vorteilhaft, daß der Laserstrahl ein Leistungsprofil auf der Targetoberfläche aufweist, das aus einem schmalen Abtragbereich mit hoher Leistung und einem breiteren Heizbereich mit niedrigerer Leistung besteht.

Die ultrafeinen Partikel werden vorzugsweise über ein in der Regel inertes Transportgas und eine gegebenenfalls zwischengeschaltete Größenselektion in eine Sammelkammer oder zu einem Substrat überführt.

Den ultrafeinen Partikeln wird vorzugsweise eine Größenverteilung mit einer Standardabweichung von höchstens 10% des mittleren Durchmessers erteilt oder es gelangen nur selektierte Partikel dieser Größenverteilung inclusive deren Agglomerate zur Sammelkammer oder zum Substrat.

Eine Dosierung der ultrafeinen Partikel erfolgt vorzugsweise durch Einstellung der Laserleistungsdichte auf der Targetauftrefffläche, der Größe des Auftreffflecks, der Relativgeschwindigkeit zwischen Target und Laserstrahl, des Gesamtdrucks in der Targetkammer und/oder durch eine Aufteilung des Trägergasstromes, wobei es vorteilhaft ist, die zuvor genannten Größen während der Verfahrensdauer konstant zu halten.

Der Gesamtdruck in der Targetkammer wird vorzugsweise so niedrig eingestellt, daß das Maximum der Größenverteilung mit der zu selektierenden Partikelgröße zusammenfällt. Dabei werden z.B. für Partikelgrößen von 10 nm oder kleiner vorzugsweise Drücke von höchstens 20 hPa, insbesondere 10 bis 1 hPa, eingestellt.

Zur Verhinderung einer Agglomeration ist es zweckmäßig, die ultrafeinen Partikel mit Ladungen gleichen Vorzeichens aufzuladen und im Fall von oxidischen Partikeln bzw. Isolatoren vorzugsweise mit einer dünnen, nur einige Monolagen dicken elektrisch leitenden bzw. metallischen Oberflächenschicht vorher zu überziehen.

Dabei ist die die ultrafeinen Partikel umhüllende Materialkomponente vorzugsweise ein Material mit in dem Partikelmaterial vernachlässigbarer fester Löslichkeit, wodurch die größenabhängigen Eigenschaften der ultrafeinen Partikel im Festkörper stabilisiert werden.

Die erfindungsgemäß hergestellten ultrafeinen Partikel sind für alle eingangs genannten Zwecke verwendbar. Bevorzugt wird jedoch die Verwendung der ultrafeinen Partikel zum Herstellen von ein- oder mehrkomponentigen Materialien oder Formkörpern aus derartigen Materialien durch Beschichtung von Substraten mit diesen ultrafeinen Partikeln.

Bei dieser Verwendung ist es vorteilhaft, daß die ultrafeinen Partikel beim Beschichten des Substrats zusammen mit einer weiteren Materialkomponente aufgebracht werden, wobei diese Komponente durch reaktive Abscheidung aus einer zusätzlichen Gasphase, d.h. durch CVD, plasma-aktivierte CVD oder laser-induzierte CVD, mit aufgebracht wird.

Bei einer weiteren Ausgestaltung des Beschichtens werden zuerst die ultrafeinen Partikel aufgebracht; anschließend erfolgt eine Verfestigung mit Hilfe von CVI = chemical vapour infiltration.

Ferner ist es vorteilhaft, daß die Substrate mit ultrafeinen Partikeln aus mehreren Materialien beschichtet werden, wobei die einzelnen ultrafeinen Partikel entweder nur aus einem Material oder aus mehreren Materialien bestehen und die Partikel anschließend durch eine wärmebehandlung gesintert und damit porös kompaktiert werden.

Eine weitere Verwendungsmöglichkeit besteht darin, daß die ultrafeinen Partikel ohne zusätzliche Verfestigung in Form von auf der Substratoberfläche fest haftenden vernetzten Kettenstrukturen und Kettenenden aufgebracht werden.

CVI = chemical vapour infiltration bedeutet CVD im Innern der Poren eines porösen Materials, wie es z.B. auch aus der Abscheidung von lockeren Partikelketten-haltigen Agglomeraten entstehen kann. Bei Agglomeraten von Ketten von BaO-, CaO- und/oder Al₂O₃-haltigen ultrafeinen Partikeln wird als reaktives Gas z.B. WF₆/H₂ zum Umhüllen der Partikelketten verwendet. Die poröse Schicht wird dabei auf für thermische CVD ausreichende Temperatur entweder direkt oder induktiv oder per Laser aufgeheizt. Bei der Abscheidung obiger Agglomerate ist eine zusätzliche Größenselektion in der Regel nicht erwünscht, der Prozeß wird also wesentlich vereinfacht. CVI kann entweder als isothermes Verfahren, d.h. das ganze Substrat befindet sich auf konstanter Temperatur, oder als Temperaturgradienten-CVI angewendet werden, wobei der Temperaturgradient in der Regel aus der Zone der stärksten Deposition heraus zum "kalten" einströmenden reaktiven Gas hin verschoben werden kann.

Um eine aus 4BaO . CaO . Al₂O₃ bestehende gefüllte Porenstruktur in einer W-Matrix mit Sc₂O₃ + W-Deckschicht zu erhalten, die als Scandat-Glühkathode gut geeignet ist und bei der Herstellung den Vorteil aufweist, in einem einzigen Abscheidungsprozeß aus der Gasphase hergestellt zu werden, wird das Target aus 4BaO . CaO . Al₂O₃ zusammengesetzt, wobei in der letzten Beschichtungsphase ultrafeine Partikel aus einem weiteren Target aus Sc₂O₃ verdampft werden und die weitere Materialkomponente zum Verfestigen der porösen Struktur Wolfram ist, das über PCVD, CVD oder CVI aus WF₆/H₂ oder einer anderen gasförmigen W-Quelle abgeschieden wird. Dies ist ein Beispiel für die Herstellung von Erdalkali-Nachlieferungskathoden ganz allgemein.

Beim erfindungsgemäßen Verfahren wird das zu überführende Material durch einen Laserstrahl mit hoher Leistungsdichte von 10⁶ bis 10⁹ W/cm² in der Auftrefffläche des Targets bei ausreichend hoher Spottemperatur verdampft, wobei entweder schon ultrafeine Partikel verdampft werden oder in der Dampfphase ultrafeine Partikel aus diesem Material entstehen, die ultrafeinen Partikel über einen Gasstrom oder thermophoretisch zu einem kalten Substrat transportiert und dort niedergeschlagen oder vor dem Niederschlagen gegebenenfalls unter Zuhilfenahme eines Plasmas zusätzlich durch reaktive Abscheidung aus der Gasphase (CVD) beschichtet und abgeschieden werden oder in einem Plasma zerlegt und auf dem Substrat abgeschieden werden. Ebenfalls möglich ist eine Aufladung der ultrafeinen Partikel und ein gezielter Transport mit Hilfe eines elektrischen Feldes.

Im folgenden wird das erfindungsgemäße Verfahren, aufgegliedert in die vier Verfahrensschritte Erzeugung, Nachweis, Überführung und Abscheidung der ultrafeinen Partikel, näher beschrieben.

### 1) Erzeugung von ultrafeinen Partikeln durch laserinduzierte Verdampfung:

Wichtige Parameter für eine gesteuerte Erzeugung von ultrafeinen Partikeln durch Einwirkung eines Lasers auf eine Materialoberfläche sind
- Laserintensität I in der Auftrefffläche
- Absorptionsvermögen A (λ) der Oberfläche
- Wärmeleitfähigkeit χ des Materials
- Schmelz- und Siedepunkt des Materials
- Gleichgewichtspartialdrücke über dem reinen Material als Funktion der Temperatur.

Zunächst muß eine ausreichende Leistungsdichte von mehr als 10⁶ Watt/cm² in der Auftrefffläche des Laserstrahls vorhanden sein. Damit diese Bedingung erfüllt werden kann, müssen entsprechend leistungsstarke Laser angewendet werden; geeignet sind z.B. CO₂-Laser (λ = 10,6 µm), NdYAG-Laser (λ = 1,06 µm) und KrF-Laser (λ = 0,250 µm).

Zusammen mit einer fokussierenden Linse können im Laser-Fokus folgende Leistungsdichten erreicht werden:

| | |
|---|---|
| CO₂-Laser: | 10⁸ W/cm² |
| NdYAG-Laser: | 5 . 10¹¹ W/cm² |
| KrF-Laser: | 2 . 10¹¹ W/cm² |
| andere Eximer-Laser (ArF, KrCl): | 2 . 10¹⁰ W/cm² |

Diese Daten beziehen sich auf gepulsten Betrieb, jedoch kann ein CO₂-Laser mit ausreichender CW-Leistung (etwa 100 Watt) ebenfalls zur Materialverdampfung und auch zur Partikelerzeugung verwendet werden.

Nun ist jedoch für die Partikelerzeugung eine wichtige Einschränkung zu beachten: Oberhalb einer materialabhängigen Schwellenintensität Iₛ
(z.B. bei Cu und λ = 1,06 µm: Iₛ = 8 . 10⁷ W/cm² (Tₚ = 200 nsec, wobei Tₚ = Pulsdauer)
oder bei Al und λ = 250 nm: Iₛ = 2 . 10⁸ W/cm²)
steigt das Absorptionsvermögen A(λ) der Oberfläche, das für Metalle im nahen Infrarot bereits sehr niedrig ist, sprunghaft auf 1 an (anomale Absorption). Dies wird dadurch bewirkt, daß ab einer gewissen Leistungsdichte im Dampf über der Oberfläche eine Gasentladung auftritt und das so entstandene Plasma die Laserleistung nun vollständig absorbiert. Bei weiterer Steigerung der Leistungsdichte wird schließlich die Strahlungsintensität vollständig von der Oberfläche abgeschirmt, und das Plasma löst sich mit hohen Geschwindigkeiten in Richtung Lasereinfall ab (G. Herziger, E.W. Kreutz: "Fundamentals of Laser Micromachining of Metals" Proc. Int. Conf. on Laser Processing and Diagnostics, Linz 1984, S. 90-106; G. Herziger: "Technische Anwendungen von IR-Lasern in der thermischen Materialbearbeitung" Verhandlungen der DPG 7/1986, s. 1735-1763).

Der Bereich der Plasma-Abschirmung ist für die Materialbearbeitung unerwünscht, da der Prozeß dann unkontrollierbar wird. Zum Zwecke der Partikelbildung ist jedoch auch der übliche Leistungsbereich bei der Bearbeitung (z.B. bei Al 3 . 10⁶ W/cm² bis 3 . 10⁷ W/cm² für λ = 10,6 µm) nicht vorteilhaft, da das Plasma dann wiederum auch eine Zerstörung und/oder Fraktionierung schon vorhandener ultrafeiner Partikel bewirkt. Andererseits muß aber auch die Leistungsdichte für Verdampfung und Partikelentstehung ausreichen, d.h. eine gute Regulierung und Einstellung der Leistungsdichte in der Auftrefffläche ist erfindungsgemäß erforderlich. Die Partikelbildung in der Gasphase erfolgt bei übersättigtem Dampf (wenn also der Partialdruck bei der Temperatur T über der Oberfläche deutlich über dem Sättigungsdampfdruck liegt), oder es verdampfen direkt kleine Flüssigtröpfchen, was vor allem bei Materialien wie Sc₂O₃, die sich in der Gasphase zersetzen, von Vorteil ist.

Da jedoch nun eine Laserintensität I < Iₛ eingesetzt werden sollte, ist es insbesondere für Metalle im nahen IR (NdYAG-Laser und CO₂-Laser) zweckmäßig, weitere Maßnahmen zu treffen, um das Absorptionsvermögen zu erhöhen und einen effektiveren Lasereinsatz zu erreichen.

Erfindungsgemäß sind dies: Aufrauhen bzw. Schmirgeln der Metalloberfläche, Oxidieren der Metalloberfläche, so daß durch höhere Leistungsaufnahme zu Beginn eine höhere Endtemperatur erreicht wird, oder Bestrahlen eines porösen Preßlings. Eine weitere Möglichkeit der Erhöhung der Infrarotabsorption bei Metallen besteht darin, mit einem zweiten Laser niedrigerer Leistung im Sichtbaren die Targetfläche zu bestrahlen. Da die Lasereinwirkung auf die Targetoberfläche zu einer starken Veränderung wie Abtragung und Lochbildung führt und damit auch zu einer zeitlichen Änderung der verdampften Materialmenge, wird entweder der Laserstrahl oder relativ zum Laserstrahl das Substrat kontinuierlich in einem Mäanderraster weiterbewegt, um konstante Partikelmengen zu erhalten.

### 2) Partikelnachweis:

Weiter unten wird der Partikelnachweis mit Hilfe eines HeNe-Laserstrahls durch Ausstreuung an den Partikeloberflächen und dadurch verursachte Intensitätsminderung des Strahls beschrieben. Bei kleinen Partikeln gibt es auch die Möglichkeit des massenspektrometrischen Nachweises und Aufladung (mit e⁻-Strahl) oder geringfügiger Ionisation. Ein weiterer Partikelnachweis ist mit Ausnutzung der Partikelüberführung und Wiegen von Target und Substrat nach längeren Überführungszeiten möglich.

### 3) Partikeltransport:

Beispiele für den Partikeltransport werden weiter unten gegeben. Möglichkeiten sind: thermophoretisch in Richtung kältere Temperaturbereiche oder mit Hilfe einer transportierenden Gasströmung, z.B. von Ar-Gas, das aus einer geeignet geformten Düse auf den Target-Brennpunkt geblasen wird, oder auch Kr, N₂, O₂ oder z.B. Ar mit O₂ als zusätzlichem oxidierendem Gas. Eine weitere Transportmöglichkeit ist die geringfügige Aufladung der Partikel z.B. mit einem im Auftreffbereich niederenergetischen Elektronenstrahl und weitere Steuerung der Partikel durch ein elektrisches und/oder magnetisches Feld. Zur Ausnutzung der erstgenannten Thermodiffusion ist es vorteilhaft, ein Temperaturgefälle in der Gasphase durch folgende erfindungsgemäße Maßnahmen einzustellen, die das Ziel haben, daß sich ein kälterer Gasschlauch zwischen heißeren Außenbereichen bildet, der sich (vom Targetfleck) zu dem noch kälteren Substrat erstreckt. Die Maßnahmen sind:
- aufgeheizte Führungswände, dazwischen einströmendes kälteres Gas
- Randaufheizen eines Strömungsschlauchs durch Lasereinstrahlung der Wellenlänge λ in eine geeignete Gasphase mit starker Resonanzabsorption bei λ
- gekühlte Transportgasdüse und laminare Strömung
- Laser-Gaskühlung durch stimulierte Emission aus angeregtem Zustand und geeigneter Wellenlänge, bei der nur geringe Ausstreuung durch ultrafeine Partikel erfolgt.

### 4) Partikelabscheidung:

Die Partikelabscheidung erfolgt entweder über Thermodiffusion auf einem kalten Substrat oder mit Hilfe geladener Partikel und einer elektrischen Spannung auf der Substratelektrode, oder die Partikel werden in einem Plasma oder mit Hilfe eines zweiten CO₂- oder NdYAG-Lasers aufgelöst und auf einem heißen und/oder geeignet elektrisch gepolten Substrat niedergeschlagen.

### 5) Anwendungen:

Eine typische Anwendung ist die Partikelüberführung von kaum flüchtigen Alkali- und Erdalkaliverbindungen z.B. für CVD (PCVD)-Anwendungen, die sonst nicht möglich ist. Damit wird erstmals eine komplette Herstellung von Erdalkali (Ba, Sr, Ca)-Dispenserkathoden wie z.B. I-Kathode über gesteuerten Partikeltransport und Partikelabscheidung, also auch eine Gasphasentechnik, ermöglicht, im Unterschied zu den konventionellen "pulverkeramischen" Herstellungsverfahren.

Eine weitere wichtige Anwendung sind die neuen Supraleiter auf Ba, Y, La + CuO-Basis, für die damit ein neues Herstellungsverfahren angeboten wird, das neue Strukturgebungsmöglichkeiten eröffnet.

Die Erfindung wird nachfolgend anhand einer Zeichnung und einiger Ausführungsbeispiele näher erläutert. In der Zeichnung zeigen
- Fig. 1: eine grundlegende schematische Darstellung einer laserinduzierten Partikelerzeugung,
- Fig. 2: eine schematische Darstellung einer laserinduzierten Partikelerzeugung nach der Erfindung,
- Fig. 2a: ein Intensitätsprofil eines Laserstrahls,
- Fig. 3a und 3b: eine weitere schematische Darstellung einer laserinduzierten Partikelerzeugung nach der Erfindung in einem Querschnitt (Fig. 3a) und in einem weiteren Querschnitt (Fig. 3b) senkrecht zum Querschnitt nach Fig. 3a,
- Fig. 4a und 4b: eine schematische Darstellung einer Anordnung zur Einbettung von ultrafeinen Partikeln in eine CVD-Schicht im Querschnitt (Fig. 4a) und in Aufsicht (Fig. 4b),
- Fig. 4c: eine weitere Ausgestaltung der Einbettung nach Fig. 4a und 4b,
- Fig. 5: eine schematische Darstellung der Einwirkung eines Laserstrahls auf ein Target und
- Fig. 6 und 7: schematische Darstellungen von Verfahrensabläufen bei CVI.

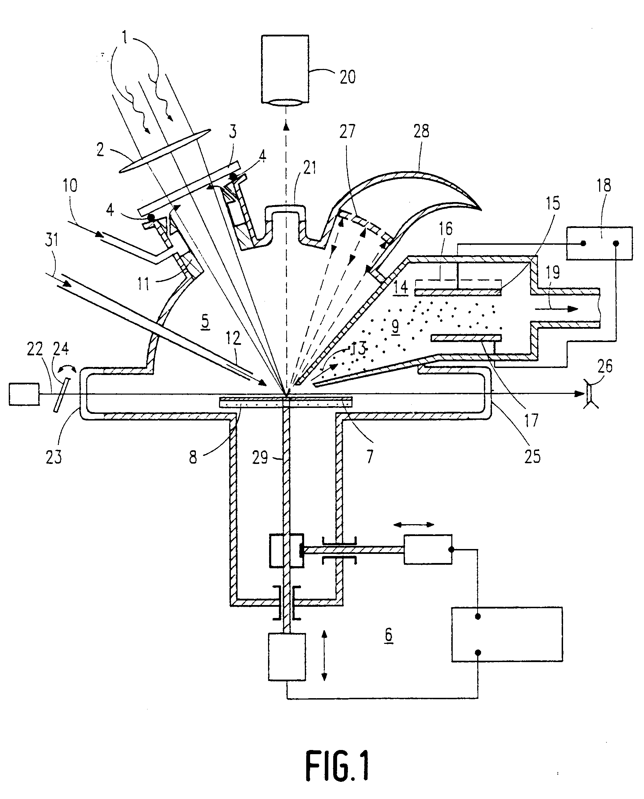

Wie in Fig. 1 dargestellt, tritt ein CO₂-Laserstrahl 1 mit einer Wellenlänge λ = 10,6 µm (oder ein NdYAG-Laserstrahl, λ = 1,06 µm) durch eine Fokussierlinse 2, z.B. aus ZnSe, (plankonvex oder besser mit Positiv-Meniskus) und ein IR-Fenster 3, z.B. aus ZnSe, mit Dichtungsring 4, in eine Kammer 5 ein und trifft (leicht schräg) im Fokus auf eine (durch eine schematisch dargestellte Motor-Programm-Steuerung 6) dreidimensional gesteuerte bewegbare Targetplatte 7 auf. Die Targetplatte kann durch eine Zusatzheizung 8 nach Bedarf zusätzlich aufgeheizt werden. Bei einer Leistungsdichte von 10⁶ bis 10⁷ Watt/cm² im Fokus wird das Targetmaterial dort über den Schmelzpunkt erhitzt, verdampft teilweise, und es bilden sich in der stark übersättigten Dampfphase Partikel 9 bzw. es dampfen Partikel 9 direkt von der Oberfläche ab. Das ZnSe-Fenster 3 wird durch ein inertes Spülgas (Pfeil 10) von eventuellen Aufdampfschichten freigehalten (Einsatz 11 mit Düsen für Spülgas).

Die direkt über dem Auftreffpunkt gebildeten ultrafeinen Partikel 9 werden durch ein inertes Transportgas 31, das durch eine Düse 12 auf die Targetfläche geblasen wird, durch eine geheizte Absaugöffnung (Pfeil 13) zu einer Depositionskammer 14 transportiert und treffen dort auf eine gekühlte Substratelektrode 15 auf (Kühlung 16). Zwischen Substratelektrode 15 und Gegenelektrode 17 kann fakultativ eine Gleichstrom- oder Wechselstrom-Glimmentladung gezündet werden (Spannungsversorgung 18), und es können zusätzlich reaktive Gase für CVD bzw. PCVD in die Depositionskammer 14 eingelassen werden. Transportgase und reaktive Gaze bzw. gasförmige Reaktionsprodukte werden von einer Pumpe zu einer Gasentsorgung hin abgesaugt (Pfeil 19), und es wird in der Depositionskammer 14 ein Druck von etwa 1 bis 100 hPa aufrechterhalten, während der Druck in der Verdampferkammer 5 bei etwa 100 bis 1000 hPa liegt (Austrittsdruck in der Gasdüse: einige 10⁵ Pa). Senkrecht zur Auftrefffläche des Laserstrahls wird die Spottemperatur über ein Infrarotpyrometer 20 (Sichtfenster 21) gemessen und z.B. über die Fokuspositionierung nachreguliert. Um einen zeitlich konstanten Partikelfluß zu erzielen und nicht eine starke lokale Änderung der Oberflächengeometrie durch eine unbeabsichtigte Lochbildung zu bekommen, wird das Target 7 kontinuierlich z.B. nach einem Mäanderraster computergesteuert weiterbewegt. Die entstandenen Partikel werden z.B. über einen He-Ne-Laserstrahl 22, der über ein gespültes Fenster 23 (hier Spüleinsatz nicht dargestellt) in die Kammer 5 eintritt und parallel zur Targetplatte 7 über dem erhitzten Fleck (Strahlhöhe über der Platte z.B. verstellbar über eine drehbare planparallele Platte 24 vor dem Fenster 23) geführt wird und durch ein ebenfalls gespültes Sichtfenster 25 auf einen Fotodetektor 26 auftrifft, über Lichtausstreuung und damit Intensitätsminderung des HeNe-Strahls nachgewiesen.

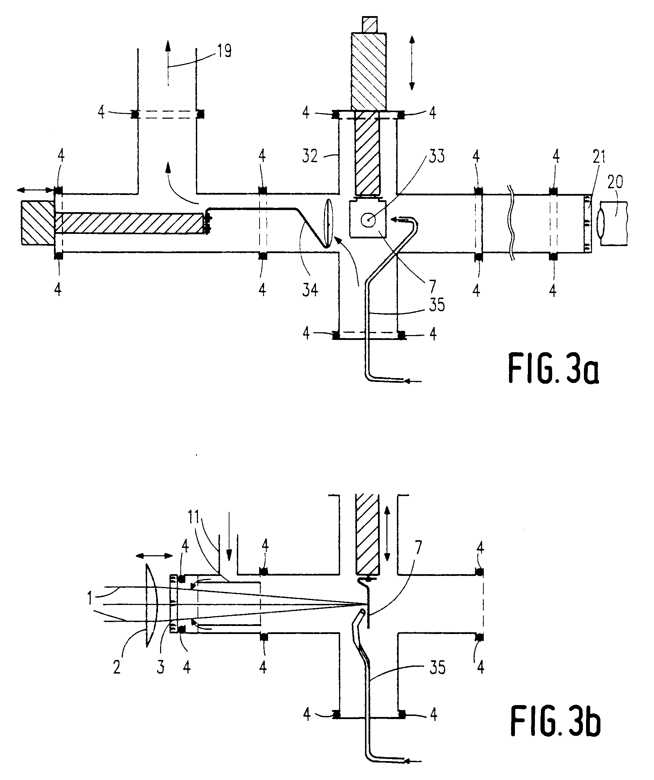

Der von der Targetoberfläche reflektierte Anteil des CO₂-Laserstrahls wird entweder von einem gekrümmten sphärischen Hohlspiegel 27 auf den Brennfleck zurückreflektiert oder bei stärker streuenden Oberflächen in einem Absorber 28 (z.B. Woodsches Horn) oder "Sumpf" absorbiert. Die Polarisation des IR-Laserstrahls ist zweckmäßigerweise zirkular, um Anisotropien bei der Verdampfung mit linear polarisiertem Strahl zu vermeiden. Es kann jedoch auch ein linear polarisierter Strahl benutzt werden (vergl. Fig. 3), und es können auch andere Einfallswinkel als der in Fig. 1 dargestellte benutzt werden. Auch können Plasmakammer (PCVD, CVD) und Depositionskammer räumlich voneinander getrennt nacheinander angeordnet sein.

Eine Variante der in Fig. 1 dargestellten Anordnung besteht darin, daß die Targetplatte 7 ein runder "Teller" ist, der mit der Winkelgeschwindigkeit um die dort dargestellte Achse 29 drehbar ist, wobei die Achse zusätzlich parallel relativ zum Auftreffpunkt des Laserstrahls linear verschoben werden kann. Der Auftreffpunkt liegt in der Regel exzentrisch.

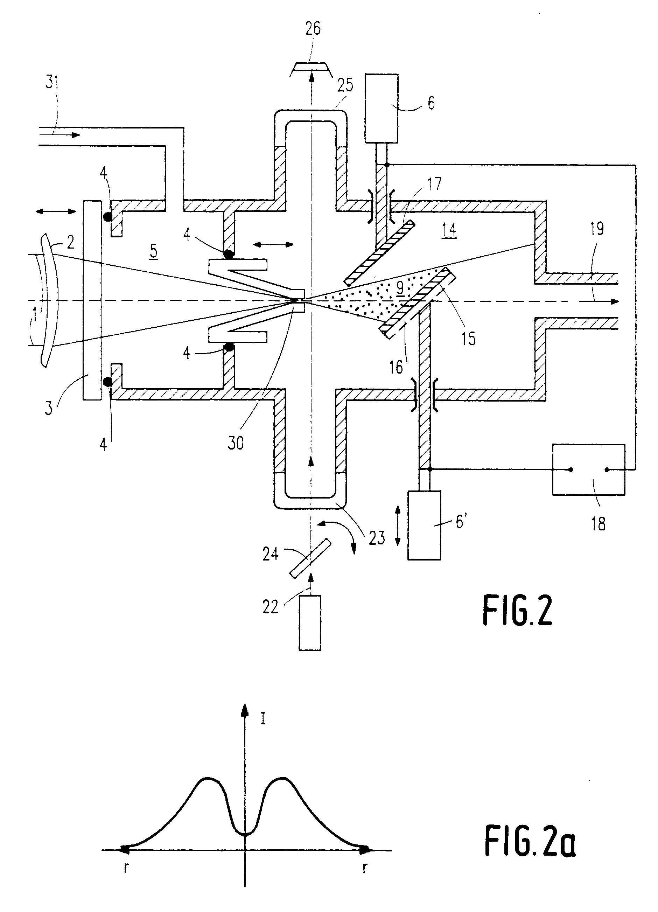

Eine erfindungsgemäße Anordnung ist in Fig. 2 dargestellt. Hierbei trifft der NdYAG- oder CO₂-Laserstrahl 1 nicht nahezu senkrecht wie bei Fig. 1 auf, sondern wird in schwach streifendem Einfall im Fokusbereich in eine entsprechend stark verengte Targetdüse 30 fokussiert. Ein inertes (oder reaktives) Transportgas 31 tritt in die Targetkammer 5 ein und strömt durch die Targetdüse 30 in die Depositionskammer 14 aus und transportiert dabei die in der (und nach der) Düse entstehenden Partikel 9 zur Substratoberfläche 15. Der IR-Laserstrahl (oder UV-Laserstrahl) 1 ist dabei zweckmäßigerweise zirkular polarisiert und hat statt eines gaussförmigen oder kastenförmigen radialen Intensitätsprofils vorteilhafterweise ein ring- bzw. "vulkan"förmiges Intensitätsprofil, wie es z.B. beim CO₂-Laser bei leichtem Dejustieren problemlos erzielt werden kann (Fig. 2a, wobei I = Intensität, r = Radius). Dadurch können auch etwas größere Targetkegelöffnungen benutzt werden.

Der flach streifende Einfall hat den Vorteil einer bis zu 50fach höheren elektrischen Feldstärke an der Oberfläche im Vergleich zum senkrechten Einfall, jedoch natürlich den Nachteil der mit dem Einfallswinkel abnehmenden Flächenintensität. Der Targetkegeldüseneinsatz kann über eine in Fig. 2 nicht dargestellte Lineardurchführung - in Dichtringen 4 gleitend - in Strahleinfallsrichtung verschoben werden. Eine Fokus-Verschiebung kann auch durch eine Linearverschiebung der Einfalls-Sammellinse 2 auf der Strahlachse erreicht werden.

Direkt hinter der Kegeldüsenöffnung wird z.B. ein He-Ne-Laserstrahl 22 zum Partikelnachweis eingestrahlt, und es wird die Partikelbildung über eine Intensitätsminderung des Strahls registriert. Die Substratelektrode 15, auf die der Partikelstrahl auftrifft, ist mit einer variablen Temperatureinstellung 16 (Kühlung oder Heizung) versehen und kann in allen drei Raumrichtungen linear verschoben werden (Vorrichtung 6'). Eine Gegenelektrode 17 ermöglicht das Anlegen einer Gleich- oder einer Wechselspannung (Spannungsversorgung 18) zwischen dieser und dem Substrat 15 und damit die Ausbildung einer Glimmentladung. Zusätzlich können noch reaktive Gaze eingeleitet werden (hier nicht dargestellt), und es können die Partikel per CVD oder PCVD beschichtet oder im Plasma aufgelöst und auf dem Substrat niedergeschlagen werden.

Eine weitere Anordnung ist in Fig. 3a und 3b dargestellt: Das Target 7 ist dabei ein dünnes, linear verschiebbares Metallblech, auf das der CO₂-Laserstrahl 1 im Fokus, leicht geneigt zur Oberflächennormalen, auftrifft, wobei eine Fokusjustierung durch eine Relativverschiebung der ZnSe-Sammellinse (Ge-Sammellinse) 2 in Richtung der Strahlachse erreicht wird. Durch den Winkel zwischen Strahlachse und Targetnormalen von einigen Grad werden Rückreflektionen des Laserstrahls und damit mögliche Leistungsfluktuationen vermieden.

Das Strahleintrittsfenster 3 (ZnSe) wird außerdem über einen Spülgas-Düseneinsatz 11 mit inertem Spülgas von innen gespült, um Fensterbeschichtungen zu vermeiden. Das Target 7 ist übrigens im Mittelpunkt eines dreidimensionalen Kreuzstücks 32 angeordnet. Die Brennfleck temperatur wird über ein Pyrometer 20 durch Messung der Temperatur auf der Blechrückseite (an der Brennfleckstelle 33) kontrolliert, und der Fokus wird so in der Regel auf maximale Temperatur nachjustiert. Ein Auffängerblech 34 sitzt in Pumprichtung 19 dem Target 7 gegenüber, deckt in einer erfindungsgemäßen Version fast den gesamten Pumpquerschnitt ab, mit Ausnahme einer zentralen runden Blendenöffnung, hinter der das eigentliche Substrat sitzt. Zusätzlich kann über eine Transportgasdüse 35 auch noch eine Partikelausblasung in Richtung Auffänger erreicht werden.

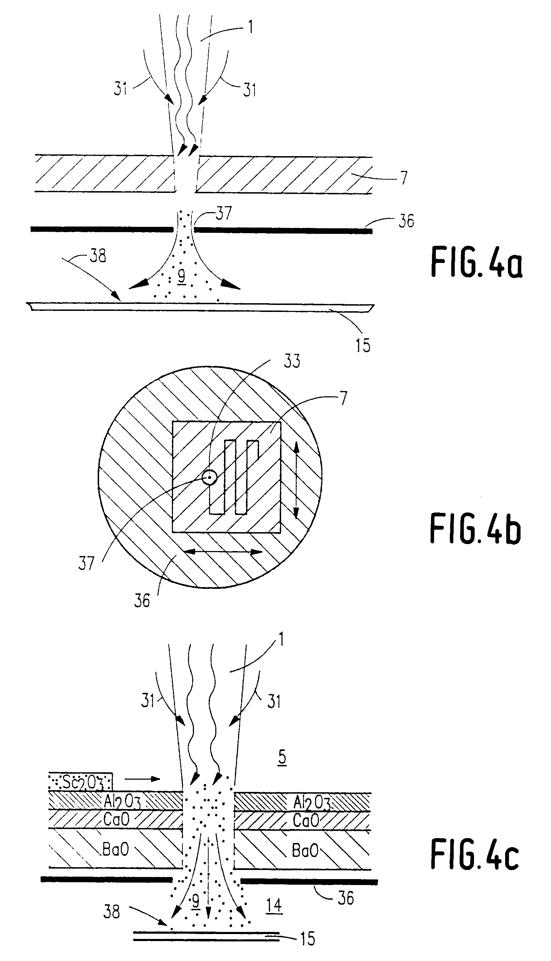

Eine Anordnung zur Einbettung von ultrafeinen Partikeln, z.B. aus BaO oder Sc₂O₃ oder SiO₂, in eine z.B. über thermische CVD abgeschiedene Wolfram-Schicht (oder andere Metallschicht) ist in Fig. 4a und 4b dargestellt. Darin ist ein inertes Transportgas, z.B. Argon, durch Pfeile 31 angedeutet. Zwischen einem (x-y) verschiebbaren Target 7, z.B. aus SiO₂, BaO oder Sc₂O₃, und einem geheizten Substrat 15 ist eine ortsfeste Blende 36 mit einer Blendenöffnung 37 für erzwungene Transportgasströmung angeordnet.

Hierbei werden ultrafeine Partikel nicht nur von der Oberfläche des Targets abgedampft, sondern das Target wird vom Laserstrahl total durchbohrt und die kontinuierliche Nachlieferung von ultrafeinen Partikeln erfolgt durch Relativbewegung des Targets senkrecht zum ortsfesten Laserstrahl(-fokus). Die ebenfalls ortsfeste Blende hinter dem Target mit einer Öffnung im Bereich des Laserstrahls bewirkt, daß das inerte Transportgas nur durch diese Öffnung, in der momentan ultrafeine Partikel verdampft werden, und nicht durch die bereits in das Target/Sedimentationskammer ausströmt.

Das die ultrafeinen Partikel 9 aus Targetmaterial (z.B. BaO, Sc₂O₃) überführende inerte Transportgas 31 trifft dann auf ein Substrat 15 auf, auf dem aus WF₆ + H₂ (Pfeil 38) Wolfram z.B. über CVD, hier thermische CVD, abgeschieden wird und um die ebenfalls auftreffenden ultrafeinen Partikel herumwächst, so daß eine Materialstruktur aus W mit BaO/Sc₂O₃-Partikeleinbettungen entsteht.

Mit einer solchen Anordnung können insbesondere Erdalkali-Nachlieferungskathoden in einem einzigen kontinuierlichen Verfahren hergestellt werden, das die vielen bisherigen Einzelschritte bei der Herstellung, wie Pulverpressen und Sintern zur porösen W-Matrix, Imprägnieren, Aufbringen der Deckschicht, ersetzt. Dadurch werden I-Kathoden für eine Massenproduktion zugänglich.

Die Ausführung ist in Fig. 4c dargestellt: In der Anordnung nach Fig. 4a und 4b wird das Target 7, das übrigens auch direkt lose auf der Blende 36 aufliegen kann, durch ein Target aus vier verschiedenen Schichten ersetzt.

Dabei liegen drei Targetplättchen, jeweils bestehend aus BaO (1 mm dick), CaO (0,5 mm dick) und Al₂O₃ (0,5 mm dick), lose gestapelt aufeinander und werden über zwei Linearführungen z.B. mäanderförmig relativ zum Laserspot verschoben. In der Regel sind diese Targets relativ poröse Preßlinge. Obendrauf befindet sich ein unabhängig von diesen Targets ebenfalls x-y-verschiebbares Sc₂O₃-Plättchen, das erst in der letzten Abscheidungsphase über den Laserspot geschoben wird.

Anstelle der drei verschiedenen Plättchen aus BaO, CaO und Al₂O₃ kann auch ein Targetpreßling benutzt werden, der aus einer Mischung BaO:CaO:Al₂O₃ im Verhältnis 4:1:1 besteht.

Es werden nun z.B. folgende Verfahrensparameter eingestellt: Substrattemperatur 500 bis 600°C, WF₆-Fluß 50 sccm, H₂-Fluß 500 sccm, Ar-Fluß 300 sccm, Druck im Depositionskammerteil 14 10 bis 20 hPa, Druck im Bereich 5 des einströmenden Transportgases 100 bis 200 hPa, Laserleistung 50 Watt, Brennweite der fokussierenden Linse 5,2 cm. Bei einer Target-Abtragungsrate von 0,07 g/min und einer W-Abscheidungsrate von etwa 0,3 g/min können schon in einer Beschichtungsdauer von etwa 10 min 1 mm dicke I-Kathodenschichten auf einer Fläche von etwa 1 cm² hergestellt werden. In der letzten Minute der Beschichtungszeit wird dabei zusätzlich das Sc₂O₃-Targetplättchen in den Laserspot verschoben.

Fakultativ kann die Deckschicht auch mit herausgezogenen 4 BaO.CaO.Al₂O₃-Targets abgeschieden werden.

Das Substrat wird in der Regel abgelöst, entweder mechanisch oder durch selektives Ätzen oder durch Benutzung eines Substrats, auf dem die W-CVD + Partikeleinbettungsschicht nicht haftet.

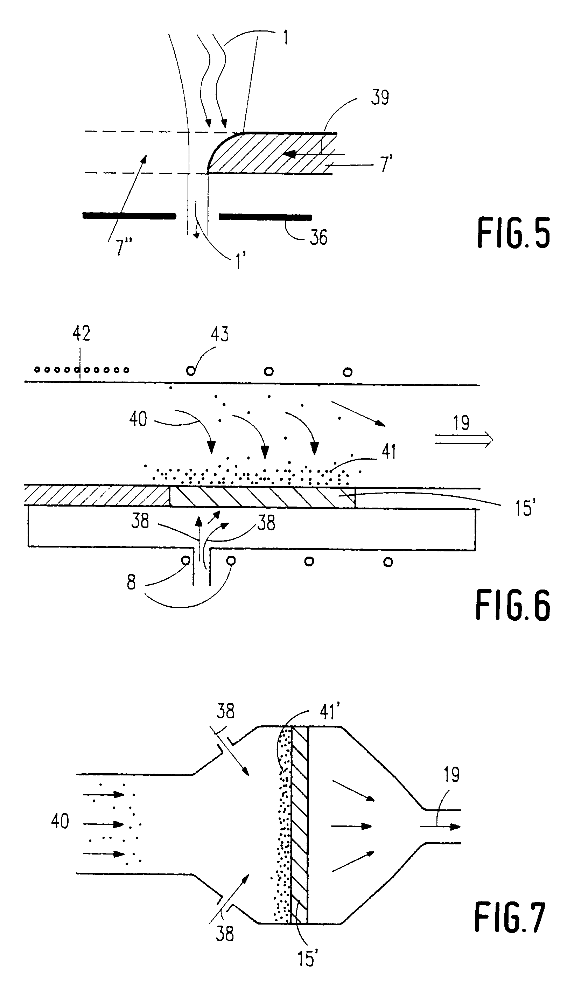

Fig. 5 zeigt, wie von einem Laserstrahl 1 getroffenes Targetmaterial in Strahlungsrichtung vollständig abgetragen wird, wobei der größte Teil des Strahls mit dem Target in Wechselwirkung tritt und nur ein kleiner Teil 1' am Resttarget 7' vorbeigeht. Es erfolgt also eine Randabtragung, indem der Laserstrahl relativ zum Target in der Targetrandzone am Targetrand entlangbewegt wird (Pfeil 39) und bei geeigneter Einstellung der Laserparameter wie Leistung, Leistungsdichte sowie der Relativgeschwindigkeit den Targetrand jeweils komplett abträgt. Der bereits abgetragene Targetteil ist mit 7'' bezeichnet.

In den Fig. 6 und 7 sind Verfahrensabläufe bei der chemical vapour infiltration CVI schematisch dargestellt. Aus einem Partikelstrom 40 mit Inertträgergas wird eine Schicht 41 aus ultrafeinen Partikeln (Fig. 6) bzw. aus kettenhaltigen Agglomeraten 41' (Fig. 7) auf bzw. an einem porösen Substrat 15' abgelagert. Die Schichten 41 bzw. 41' und die porösen Substrate 15' werden von einem reaktiven Gas, z.B. WF₆/H₂, durchströmt (Pfeile 38). 42 bedeutet eine ohmsche Heizwicklung und 43 eine Spule für induktive Heizung.

In Fig. 7 können folgende Materialströme vertauscht werden: 19 gegen 38 bei Umkehrung der Richtung; 38 gegen 40; 40 gegen 19 bei Umkehrung der Richtung.

Auch kann die Abscheidung von Agglomeraten ultrafeiner Partikel und die CVI-Verfestigung nacheinander durchgeführt werden.

## Patentansprüche

1. Verfahren zum Herstellen von ultrafeinen Partikeln mit Durchmessern im Bereich von 1 bis 100 nm, die durch Laserstrahlverdampfung aus einem Target erzeugt werden,
dadurch gekennzeichnet, daß der Laserstrahl relativ zum Target in der Targetrandzone am Targetrand entlang bewegt wird und bei geeigneter Einstellung der Laserparameter Leistung, Leistungsdichte sowie der Relativgeschwindigkeit den Targetrand jeweils komplett abträgt.

2. Verfahren nach Anspruch 1,
dadurch gekennzeichnet, daß die abdampfenden ultrafeinen Partikel durch ein Loch im Target hindurch und gegebenenfalls noch durch eine zusätzliche Blende abströmen.

3. Verfahren nach Anspruch 1 oder 2,
dadurch gekennzeichnet, daß die Oberfläche des Targets vor Beginn der Abtragung aufgerauht, geschmirgelt oder oxidiert wird.

4. Verfahren nach Anspruch 1 oder 2,
dadurch gekennzeichnet, daß als Target ein poröser Preßling verwendet wird.

5. Verfahren nach Anspruch 1, 2, 3 oder 4,
dadurch gekennzeichnet, daß verschiedene Materialkomponenten gleichzeitig verdampft und ultrafeine Partikel daraus erzeugt werden.

6. Verfahren nach einem oder mehreren der Ansprüche 1 bis 5,
dadurch gekennzeichnet, daß das Target direkt oder indirekt aufgeheizt wird.

7. Verfahren nach einem oder mehreren der Ansprüche 1 bis 6,
dadurch gekennzeichnet, daß die Laserstrahlverdampfung aus dem Target vor, im oder hinter dem Fokus eines fokussierten Strahls erfolgt.

8. Verfahren nach Anspruch 7,
dadurch gekennzeichnet, daß die Fokussierung in oder außerhalb einer Targetkammer durch einen sphärischen fokussierenden Spiegel, der mit Inertgas gespült wird, erfolgt.

9. Verfahren nach einem oder mehreren der Ansprüche 1 bis 8,
dadurch gekennzeichnet, daß der Laserstrahl ein Leistungsprofil auf der Targetoberfläche aufweist, das aus einem schmalen Abtragbereich mit hoher Leistung und einem breiteren Heizbereich mit niedrigerer Leistung besteht.

10. Verfahren nach einem oder mehreren der Ansprüche 1 bis 9,
dadurch gekennzeichnet, daß die ultrafeinen Partikel über ein in der Regel inertes Transportgas und eine gegebenenfalls zwischengeschaltete Größenselektion in eine Sammelkammer oder zu einem Substrat überführt werden.

11. Verfahren nach einem oder mehreren der Ansprüche 1 bis 10,
dadurch gekennzeichnet, daß den ultrafeinen Partikeln eine Größenverteilung mit einer Standardabweichung von höchstens 10% des mittleren Durchmessers erteilt wird oder daß nur selektierte Partikel dieser Größenverteilung inclusive deren Agglomerate zur Sammelkammer oder zum Substrat gelangen.

12. Verfahren nach einem oder mehreren der Ansprüche 1 bis 11,
dadurch gekennzeichnet, daß eine Dosierung der ultrafeinen Partikel durch Einstellung der Laserleistungsdichte auf der Targetauftrefffläche, der Größe des Auftreffflecks, der Relativgeschwindigkeit zwischen Target und Laserstrahl, des Gesamtdrucks in der Targetkammer und/oder eine Aufteilung des Trägergasstromes erfolgt.

13. Verfahren nach Anspruch 12,
dadurch gekennzeichnet, daß die genannten Größen während der Verfahrensdauer konstant gehalten werden.

14. Verfahren nach Anspruch 12 oder 13,
dadurch gekennzeichnet, daß der Gesamtdruck in der Targetkammer so niedrig eingestellt wird, daß das Maximum der Größenverteilung mit der zu selektierenden Partikelgröße zusammenfällt.

15. Verfahren nach einem oder mehreren der Ansprüche 1 bis 14,
dadurch gekennzeichnet, daß die ultrafeinen Partikel mit Ladungen gleichen Vorzeichens aufgeladen werden und im Fall von oxidischen Partikeln bzw. Isolatoren vorzugsweise mit einer dünnen, nur einige Monolagen dicken elektrisch leitenden bzw. metallischen Oberflächenschicht vorher überzogen werden.

16. Verfahren nach Anspruch 15,
dadurch gekennzeichnet, daß die die ultrafeinen Partikel umhüllende Materialkomponente ein Material mit in dem Partikel-Material vernachlässigbarer fester Löslichkeit ist.

17. Verfahren nach einem oder mehreren der Ansprüche 1 bis 16,
dadurch gekennzeichnet, daß zum Herstellen von ein- oder mehrkomponentigen Materialien oder Formkörpern Substrate mit den ultrafeinen Partikeln beschichtet werden.

18. Verfahren nach Anspruch 17,
dadurch gekennzeichnet, daß die ultrafeinen Partikel beim Beschichten des Substrats zusammen mit einer weiteren Materialkomponente aufgebracht werden, wobei diese Komponente durch reaktive Abscheidung aus einer zusätzlichen Gasphase, d.h. durch CVD, plasma-aktivierte CVD oder laser-induzierte CVD, mit aufgebracht wird.

19. Verfahren nach Anspruch 17,
dadurch gekennzeichnet, daß zuerst die ultrafeinen Partikel aufgebracht werden und anschließend eine Verfestigung mit Hilfe von CVI = chemical vapour infiltration erfolgt.

20. Verfahren nach Anspruch 17,
dadurch gekennzeichnet, daß die Substrate mit ultrafeinen Partikeln aus mehreren Materialien beschichtet werden, wobei die einzelnen ultrafeinen Partikel entweder nur aus einem Material oder aus mehreren Materialien bestehen und die Partikel anschließend durch eine Wärmebehandlung gesintert und damit porös kompaktiert werden.

21. Verfahren nach Anspruch 17,
dadurch gekennzeichnet, daß die ultrafeinen Partikel ohne zusätzliche Verfestigung in Form von auf der Substratoberfläche fest haftenden vernetzten Kettenstrukturen und Kettenenden aufgebracht werden.

22. Verfahren nach Anspruch 17,18 oder 19,
dadurch gekennzeichnet, daß das Target aus 4BaO . CaO. Al₂O₃ zusammengesetzt wird, in der letzten Beschichtungsphase ultrafeine Partikel aus einem weiteren Target aus Sc₂O₃ verdampft werden und die weitere Materialkomponente zum Verfestigen der porösen Struktur Wolfram ist, das über PCVD, CVD oder CVI aus WF₆/H₂ oder einer anderen gasförmigen W-Quelle abgeschieden wird.

## Claims

1. Method of manufacturing ultrafine particles whose diameter ranges from 1 to 100 nm and which are produced from a target by laser beam evaporation, characterized in that the laser beam is moved relative to the target in the peripheral zone of the target and along the edge thereof, and the edge of the target is completely removed when the laser parameters, such as power, power density and relative velocity, are suitably adjusted.

2. A method as claimed in Claim 1, characterized in that the ultrafine particles which are being evaporated escape through a hole in the target and, if desired, pass through an additional diaphragm.

3. A method as claimed in Claim 1 or 2, characterized in that prior to the removal operation, the surface of the target is roughened, ground or oxidized.

4. A method as claimed in Claim 1 or 2, characterized in that a porous moulded body is used as the target.

5. A method as claimed in Claim 1, 2, 3 or 4, characterized in that components of various materials are simultaneously evaporated and ultrafine particles are produced therefrom.

6. A method as claimed in one or several of the Claims 1 to 5, characterized in that the target is heated directly or indirectly.

7. A method as claimed in one or several of the Claims 1 to 6, characterized in that the laser beam evaporation from the target takes place in front of, in or behind the focus of a focused beam.

8. A method as claimed in Claim 7, characterized in that the focusing takes place inside or outside a target chamber by using a spherical focusing mirror which is rinsed with an inert gas.

9. A method as claimed in one or several of the Claims 1 to 8, characterized in that the laser beam exhibits a power profile on the target surface, which consists of a narrow material-removal region with a high power and a wider heating region with a lower power.

10. A method as claimed in one or several of the Claims 1 to 9, characterized in that the ultrafine particles are transferred to a collecting chamber or a substrate by a generally inert transport gas and, if necessary, a subsequent size selection operation.

11. A method as claimed in one or several of the Claims 1 to 10, characterized in that the ultrafine particles are given a size distribution with a standard deviation of maximally 10% from the average diameter, or in that only selected particles of said size distribution, including their agglomerates, reach the collecting chamber or the substrate.

12. A method as claimed in one or several of the Claims 1 to 11, characterized in that the desired dosage of the ultrafine particles is obtained by adjusting the values of laser-power density on the target surface, the size of the spot, the relative velocity between target and laser beam, the overall pressure in the target chamber and/or by dividing the carrier gas flow.

13. A method as claimed in Claim 12, characterized in that the said values are kept constant throughout the process.

14. A method as claimed in Claim 12 or 13, characterized in that the overall pressure in the target chamber is adjusted to be so low that the highest value on the scale of sizes coincides with the particle size to be selected.

15. A method as claimed in one or several of the Claims 1 to 14, characterized in that the ultrafine particles are given charges of the same sign, and in the case of oxidic particles or insulators, said particles or insulators are preferably previously coated with, respectively, a thin, only a few monolayers thick, electrically conducting or metallic surface layer.

16. A method as claimed in Claim 15, characterized in that the material component enveloping the ultrafine particles is a material whose solid solubility in the particle material is negligibly small.

17. A method as claimed in one or several of the Claims 1 to 16, characterized in that for the manufacture of single or multi-component materials or moulded bodies, substrates are coated with said ultrafine particles.

18. A method as claimed in Claim 17, characterized in that during the coating of the substrate, the ultrafine particles are applied together with a further component, said component being provided by reactive deposition from an additional gas phase, i.e. by CVD, plasma-activated CVD or laser-induced CVD.

19. A method as claimed in Claim 17, characterized in that first the ultrafine particles are provided and then a solidification by means of CVI = chemical vapour infiltration takes place.

20. A method as claimed in Claim 17, characterized in that the substrates are coated with ultrafine particles of various materials, the individual ultrafine particles consisting of only one material or of various materials, and said particles subsequently being sintered by a heat treatment and, thus, porously compacted.

21. A method as claimed in Claim 17, characterized in that the ultrafine particles are provided without additional solidification in the form of crosslinked chain structures and chain ends which firmly adhere to the substrate surface.

22. A method as claimed in Claims 17, 18 or 19, characterized in that the target is composed of 4BaO.CaO.Al₂O₃, and in the last coating phase ultrafine particles are evaporated from a further target of Sc₂O₃ and the further component used to solidify the porous structure is tungsten which is deposited through PCVD, CVD or CVI from WF₆/H₂ or another gaseous W-source.

## Revendications

1. Procédé de fabrication de particules ultra-fines présentant des diamètres comprises entre 1 et 100 nm, qui sont fabriquées à partir d'une cible par l'intermédiaire d'évaporation par faisceau laser, caractérisé en ce que par rapport à la cible le faisceau laser est déplacé dans la zone périphérique de cible suivant le bord de cible et que dans le cas d'un ajustage convenable des paramètres laser, savoir la puissance, la densité de puissance ainsi que la vitesse relative, le bord de cible est enlevé complètement.

2. Procédé selon la revendication 1, caractérisé en ce que les particules ultra-fines évaporées passent par une ouverture perceé dans la cible et le cas échéant encore par un diaphragme additionnel.

3. Procédé selon la revendication 1 ou 2, caractérisé en ce qu'avant le commencement de l'enlèvement la surface de la cible est rendue rugueuse, émerisée ou oxydée.

4. Procédé selon la revendication 1 ou 2, caractérisé en ce que l'on utilise comme cible un corps moulé poreux.

5. Procédé selon la revendication 1, 2 ou 3, caractérisé en ce que plusieurs constituants de matériau sont évaporés en même temps pour en fabriquer des particules ultra-fines.

6. Procédé selon l'une ou plusieurs des revendications 1 à 5, caractérisé en ce que la cible est chauffée directement ou indirectement.

7. Procédé selon l'une ou plusieurs des revendications 1 à 6, caractérisé en ce que l'évaporation au faisceau laser à partir de la cible se produit devant, dans ou derrière le foyer d'un rayon focalisé.

8. Procédé selon la revendication 7, caractérisé en ce que la focalisation est effectuée dans ou à l'extérieur d'une chambre de cible par un miroir de focalisation sphérique rincé au gaz inerte.

9. Procédé selon l'une ou plusieurs des revendications 1 à 8, caractérisé en ce que sur la surface de cible le faisceau laser présente un profil de puissance constitué d'une zone d'enlèvement de matériau étroite à puissance élevée et d'une zone de chauffage plus large à puissance faible.

10. Procédé selon l'une ou plusieurs des revendications 1 à 9, caractérisé en ce que les particules ultra-fines sont transférées en général à une chambre collectrice ou vers un substrat par l'intermédiaire d'un gaz de transport inerte et le cas échéant d'un dispositif de sélection de grosseur intercalé.

11. Procédé selon l'une ou plusieurs des revendications 1 à 10, caractérisé en ce que les particules ultra-fines présentent une distribution de grosseur dont l'écart standard est tout au plus égal à 10% du diamètre moyen ou que seulement des particules sélectionnées présentant la distribution de grosseur y compris leurs agglomérats atteignent la chambre collectrice ou le substrat.

12. Procédé selon l'une ou plusieurs des revendications 1 à 11, caractérisé en ce qu'un dosage des particules ultra-fines est effectué par l'ajustage de la densité de puissance laser sur la surface de cible, de la taille du spot de cible, de la vitesse relative entre la cible et le faisceau laser, de la pression totale régnant dans la chambre de cible et/ou qu'est effectuée une division du débit du courant de gaz porteur.

13. Procédé selon la revendication 12, caractérisé en ce que les valeurs mentionnées sont maintenues constantes lors de la durée du procédé.

14. Procédé selon la revendication 12 ou 13, caractérisé en ce que la pression totale dans la chambre de cible est ajustée à un niveau tellement bas, que le maximum de la distribution de grosseurs coïncide avec la grosseur des particules à sélectionner.

15. Procédé selon l'une ou plusieurs des revendications 1 à 14, caractérisé en ce que les particules ultra-fines de charges présentant le même signe sont chargées et que dans le cas de particules oxydiques respectivement d'isolants elles sont revêtues avantageusement d'abord d'une couche superficielle mince, d'une épaisseur de quelques monocouches seulement, électriquement conductrice respectivement métallique.

16. Procédé selon la revendication 15, caractérisé en ce que le constituant de matériau entourant les particules ultra-fines est un matériau dont la solubilité solide dans le matériau de particule est négligemment faible.

17. Procédé selon l'une ou plusieurs des revendications 1 à 16, caractérisé en ce que pour la fabrication de matériaux à un ou à plusieurs constituants ou pour la fabrication de corps moulés les substrats sont revêtus de particules ultra-fines.

18. Procédé selon la revendication 17, caractérisé en ce que lors du revêtement du substrat les particules ultra-fines sont déposées conjointement avec un autre constituant de matériau, ledit constituant étant déposé par dépôt réactif à partir d'une phase gazeuse supplémentaire, c'est-à-dire par CVD, par CVD assisté de plasma ou CVD induit au laser.

19. Procédé selon la revendication 17, caractérisé en ce que d'abord les particules ultra-fines sont déposées et que subséquemment est mis en oeuvre un procédé de solidification indiqué par CVI = chemical vapour infiltration (infiltration chimique en phase vapeur).

20. Procédé selon la revendication 17, caractérisé en ce que les substrats sont revêtus de particules ultra-fines provenant de plusieurs matériaux, les particules ultra-fines individuelles étant constituées soit d'un seul matériau ou de plusieurs matériaux et que subséquemment les particules sont frittées par un traitement thermique et compactées de manière à être poreuses.

21. Procédé selon la revendication 17, caractérisé en ce que sans solidification supplémentaire les particules ultra-fines sont appliquées en forme de structures de chaîne et d'extrémités de chaîne s'adhérant à la surface de substrat.

22. Procédé selon les revendications 17, 18 ou 19, caractérisé en ce que la cible est constituée de 4BaO . CaO . Al₂O₃, que dans la dernière phase de revêtement des particules ultra-fines sont évaporées à partir d'une autre cible en Sc₂O₃ et que l'autre constituant de matériau destiné à solidifier la structure poreuse est le tungstène qui est déposé à partir de WF₆/H₂ ou d'une autre source gazeuse W par l'intermédiaire d'un procédé de PCVD, de CVD ou de CVI.
